Europäisches Patentamt

European Patent Office

Office européen des brevets

(11) Publication number: **0 326 087**

**A2**

# EUROPEAN PATENT APPLICATION

(21) Application number: 89101208.0

(51) Int. Cl.⁴: **H01L 39/24**

(22) Date of filing: 24.01.89

(30) Priority: 27.01.88 JP 14387/88
08.06.88 JP 140701/88

(43) Date of publication of application:
**02.08.89 Bulletin 89/31**

(84) Designated Contracting States:
**DE FR GB**

(71) Applicant: FUJITSU LIMITED
1015, Kamikodanaka Nakahara-ku
Kawasaki-shi Kanagawa 211(JP)

(72) Inventor: Yoshikawa, Kohta
53-7, Sawatari Kanagawa-ku
Yokohama-shi Kanagawa, 211(JP)
Inventor: Awaji, Naoki
4-24, Sugekitaura 2-chome Tama-ku
Kawasaki-shi Kanagawa, 214(JP)

Inventor: Park, Kyung-ho
4-9, Fujimi 2-chome Kawasaki-ku
Kawasaki-shi Kanagawa, 210(JP)
Inventor: Ohsako, Nagisa
2387-33, Imajukucho Asahi-ku
Yokohama-shi Kanagawa, 241(JP)
Inventor: Ri, Seigen
Baumu Haitsu Kikuna 5-302 1-30,
Kaminomiya
Tsurumi-ku Yokohama-shi Kanagawa,
230(JP)

(74) Representative: Melzer, Wolfgang, Dipl.-Ing. et
al
Patentanwälte Mitscherlich, Gunschmann,
Körber, Schmidt-Evers, Melzer
Steinsdorfstrasse 10
D-8000 München 26(DE)

(54) **Method for fabricating a superconductive film.**

(57) A method for fabricating a superconductive film composed of a $RE_1Ba_2Cu_3O_x$ compound, or a $(Bi \cdot Sr \cdot Ca \cdot Cu \cdot O)$ compound. Oxide or carbonate of the component material, namely $Y_2O_3$, $BaCO_3$, and $CuO$ are mixed with a mixing rate of 1:2:3 in atom, according to the chemical formula of $RE_1Ba_2Cu_3O_x$, and sintered to create a rhombic perovskite structure. The sintered mixture is powdered again, and further added powder of $Y_2O_3$ with a rate of 4-6 parts of Y, and 1 part of metallic Cu powder each for 1 part of Ba, and sintered again. Such sintered pellet is used for the source (3) of electron beam evaporator. By doing so, the rhombic perovskite structure is transferred to the film, and the added materials supplemented the loss of these elements caused by the electron beam evaporation. For the $(Bi \cdot Sr \cdot Ca \cdot Cu \cdot O)$ compound, a sintered pellet composed of a mixture of one part of BiO, 3-15 parts of $SrCO_3$, 4-30 parts of $CaCO3$, and 2-5 parts of CuO, each in atomic ratio of Bi, Sr, Ca, Cu is used.

*FIG. 1*

EP 0 326 087 A2

# METHOD FOR FABRICATING A SUPERCONDUCTIVE FILM

## BACKGROUND OF THE INVENTION

### Field of the Invention

The present invention relates to a method for fabricating a superconductive film on a dielectric substrate by electron beam evaporation method. The present invention especially relates to a method for fabricating a superconductive film composed of a compound of bismuth, strontium, calcium, copper and oxygen (Bi•Sr•Ca•Cu•O), or a compound of rare earth element, barium, copper and oxygen (RE•Ba•Cu•O).

Recently, application of superconductivity in electronic devices has placed considerable emphasis on realizing a superconductive wirings of devices. For such object, fabrication of superconductive film is becoming a very important technology.

### Description of the Relevant Art

Since the discovery of a material which shows a superconductivity at a relatively high temperature by W. K. Wu et al ("Superconductivity at 93 K in a New Mixed-Phase Y-Ba-Cu-O Compound System at Ambient Pressure", Physical Review Letter, vol. 58, No. 9, 2 March 1987), extensive efforts have been dedicated in various fields of industries to discover new materials which can operate at higher temperature, and provide a stable operation. Among many of those new materials, compounds of $(RE_1 Ba_2 Cu_3 O_x)$ and compounds of (Bi•Sr•Ca•Cu•O) are becoming a main stream for the electronic application.

For fabricating a thin film of these compounds, two methods have been mainly tried, one is sputtering and the other is evaporating the materials. Both of them are technologies widely used in electronic device fabrication. Among of them, the sputtering is tried extensively, because sputtering by glow discharge of gas can handle various compounds.

In the sputtering method, a compound of superconductive material is placed in a chamber as a source, and sputtered by an electrical glow discharge generated between the source and a substrate. More can be seen in for example, "Preparation of $YBa_2 CU_3 O_{7-x}$ Superconducting Thin Films by RF-Magnetron Sputtering" by T. Aida et al. Japanese. Jour. of Appl. Phys. vol. 26, No. 9, 1987, pp. L1489-L1491. The ratio of the number of atoms of RE, Ba, Ca in the $RE_1 Ba_2 Cu_3 O_x$ compound, for example, is 1:2:3 as can be seen in this chemical molecular formula. But if a superconductive material having such an atomic ratio is used for a sputtering source, it has been found that the fabricated film does not show a superconductivity, though the source material showed the superconductivity. It is attrib uted to the fact that the sputtering rate of atoms by glow discharge is different for each atoms, accordingly, the atomic ratio in the sputtered film is shifted from the ideal one. To compensate such shift in the atomic ratio, it has been proposed to vary the rate of mixture in the source compound from that of the chemical formula. Such situation can be seen in for example "Preparation of Y-Ba-Cu-O Thin Films by Rf-Magnetron Sputtering" by H. Ohkuma et al., Japanese. Jour. of Appl. Phys. vol. 26, No. 9, Sep. 1987, pp. L1484-L1486.

Surface of superconductive films formed by sputtering of the present state-of-the-art technology is found to be rough and lacks the smoothness necessary for wiring of electron devices. This may be due to a back sputtering of the substrate caused by ion bombardment. Further, the sputtering condition varies depending on the structure of the sputtering chamber, arrangement of electrodes in the chamber, pressure of gas, voltage and frequency of the equipment. So, the sputtering condition must be determined for each of the equipments.

With regard to the evaporation method, the source material is evaporated by heating it, and deposited on a substrate. For heating up the material to evaporate it, a resistance filament heater or an electron beam is used. Recently, electron beam evaporation is widely used. The surface of the film fabricated by an evaporation method is smooth. Therefore, the evaporated film is preferable for the application to electronic device.

Generally, for fabricating a film of a compound by an evaporation method, component materials, usually metals, are put in respective crucible, and evaporated separately from each other but usually at the same time toward the substrate. The elements are reacted to each other and form the desired compound on the substrate or on the way to the substrate. By controlling the temperature of each crucible, the evaporation rate of each element can be varied. Accordingly, the deviation of the atomic ratio from the desired value can be avoided. But generally, annealing is necessary to obtain a complete compound. Without an annealing, the evaporated film does not become superconductive or requires to be cooled down to a temperature of a liquid helium to show a superconductivity. Above situation may be seen for example in "As-deposited superconducting Y-Ba-Cu-O thin films on Si, $Al_2O_3$, and $SrTiO_3$ substrates" by R. M. Silver et al., Appl. Phys. Lett. 52(25), 20 June 1988.

From a view point of application to electron device, operation temperature of the superconductive film is desirable to be as high as possible, at least it is desirable to operate at a temperature of liquid nitrogen. And it is preferable not to need an annealing, because many of electron devices, such as semiconductor devices, do not want to be heated up to high temperature.

## SUMMARY OF THE INVENTION

The object of the present invention, therefore, is to provide a method for fabricating a superconductive film which maintains its superconductivity at a temperature of liquid nitrogen (77° K).

Further object of the present invention is to provide a superconductive film applicable for electron devices.

Further object of the present invention is to provide a method for fabricating a superconductive film by evaporating a single pellet which includes all component materials.

The inventors found that component materials, especially their oxide and carbonate compounds can be used as an evaporation source of an electron beam evaporator. The evaporation source is prepared by mixing oxide and carbonate powder of the component materials, and pressed in a form of a pellet. The pellet is sintered in an air ambient, and is evaporated in an evaporator. The mixing ratio of the component materials has been determined experimentally.

Further, it has been found by the inventors that for a Bi・Sr・Ca・Cu・O type film, the row materials of yttrium oxide ($Y_2O_3$), barium carbonate ($BaCO_3$) and copper oxide ($CuO$) should once be mixed in a ratio of 1:2:3 following the molecular formula, and sintered to form a compound of $Y_1Ba_2Cu_3O_x$. Then the sintered compound is powdered again, and mixed with supplemental powders of ($Y_2O_3$) and Cu with a mixing ratio against one part of Ba, 4-6 parts of ($Y_2O_3$), and 1 part of Cu respectively. And the mixed powder of these elements are sintered again.

For the Bi・Sr・Ca・Cu・O type film, such double sintering was unnecessary. The mixing ratio of the element powder was found to have rather wide range. The mixing rate was 1 bismuth oxide (BiO): 2-3 strontium oxide (SrO): 3-30 calcium carbonate ($CaCO_3$): 2-5 copper oxide ($CuO$) in mole ratio.

Using a pellet formed by above method as an evaporation source of an electron beam evaporator, a film is formed on a substrate made of MgO or $SrTiO_3$, and it showed a superconductivity at a liquid nitrogen temperature

If a single electron beam power or a heating power is used for evaporating a single pellet which includes various materials having different vapor pressure each other, the above mentioned shortage of the component materials in the superconductive film arises. According to the present invention, therefore, the predetermined component materials having a lower vapor pressure are added to the original mixture which includes the all component materials with a mixing rate according to a chemical formula, in order to supplement the shortage of the elements in the formed film. For the $RE_1Ba_2Cu_3O_x$ compound, rare earth material (RE) and copper (Cu) are added. And for the Bi・Sr・Ca・Cu・O compound, Sr and Ca are added.

These and other objects, features and advantages of the present invention will be apparent from the following, more particular, description of the preferred embodiments of this invention, as illustrated in the accompanying drawings.

## BRIEF DESCRIPTION OF DRAWINGS

Fig. 1 is a schematic drawing illustrating an electron beam evaporator used for this invention.

Fig. 2(a) is a graph showing a temperature characteristics of resistivity of a sample A which is formed on a MgO substrate.

Fig. 2(b) is a graph showing a temperature characteristics of resistivity of a sample B formed on a MgO substrate.

EP 0 326 087 A2

Fig. 2(c) is a temperature characteristics of resistivity of a sample B formed on a $SrTiO_3$ substrate.

## DESCRIPTION OF PREFERRED EMBODIMENT

As has been described before, in ordinary methods for fabricating superconductive film by an electron beam equipment, the component materials such as Y, Ba and Cu are loaded in respective crucible in an evaporation chamber. They are independently but at the same time evaporated from each crucible toward a substrate, to compose a superconductive compound on the substrate or on the way from the source to the substrate. But the control of each elements are very critical, and as the molecular formula $Y_1 Ba_2 Cu_3 O_x$ shows, oxygen is required for forming the compound. So, oxygen is introduced in the evaporation chamber to oxidize the elements. Still a shortage of oxygen is often found in the grown film. To supplement the shortage of oxygen, the film is annealed in an air or oxygen ambient.

The inventors tried to evaporate an oxide of these element materials by electron beam, this is considered to prevent the lack of oxygen in the deposited film. Encouraged by a success in evaporation of the oxide, they tried to evaporate a mixture of oxide and carbonate of the component elements. The final method discovered by the inventor will be described with respect to some preferred embodiments.

In a first embodiment, powders of $Y_2 O_3$, $BaCO_3$ and $CuO$ are mixed with a mixing rate of 1:2:3 in atomic ratio of Y, Ba, Cu and are sintered to form a pellet of $Y_1 Ba_2 Cu_3 O_x$. The pellet is checked to show a superconductivity at a liquid nitrogen temperature. If this pellet is used as a source in the electron beam evaporator, the obtained film does not show a superconductivity. Analysis of the film showed a shortage of Y and Cu in the film. This is because $Y_2 O_3$ and $CuO$ have lower vapor pressure than BaO, which is converted from $BaCO_3$, by the prebaking and the sintering process. So, the sintered pellet of $Y_1 Ba_2 Cu_3 O_x$ is powdered again, this will be called repowdering of the pellet hereinafter, and powder of $Y_2 O_3$ and powder of metallic Cu has been added to the repowdered pellet to compensate the lacked elements in the film. Such mixture is called a second mixture hereinafter, to identify it over the original mixture (called first mixture) having the mixing rate of chemical formula. The second mixture is pressed again to form a pellet and sintered again. The conditions for forming these pellets will be described later.

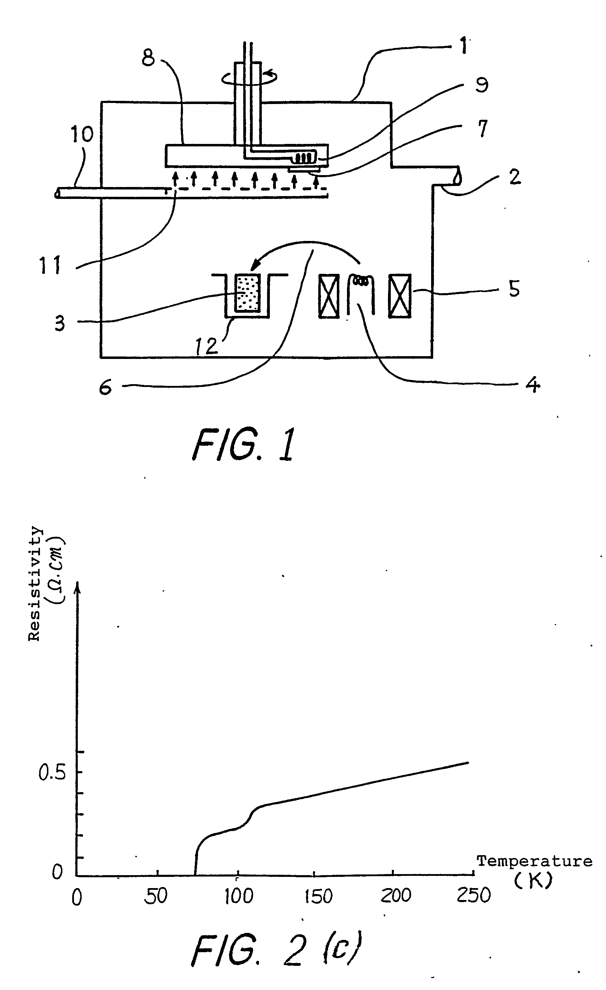

A pellet prepared in such a way is placed in an electron beam evaporator. Fig. 1 shows schematically an electron beam evaporator used in this invention. 1 is an evaporation chamber which is evacuated through an exhaust pipe 2. The pellet 3 is placed in a crucible 12 in the evaporation chamber 1. 4 is a filament, and electrons emitted from the filament 4 is focused by a magnet 5 on the source (pellet 3). The electron beam 6 is accelerated by an electric potential between the filament 4 and the source 3. A substrate 7 is supported by a rotatable holder 8. In the holder 8 is provided a heater 9 to heat up the substrate 7. The evaporation chamber 1 is provided with an oxygen inlet pipe 10, which supplies oxygen around the substrate 7 through holes 11.

The reason is still not clear that, if the additional powder of $Y_2 O_3$ and metallic powder of Cu has been added to the source mixture from the beginning of the pellet making, the formed film showed the superconductivity only at a temperature of liquid helium, and did not showed the superconductivity at a liquid nitrogen temperature. But with a pellet which is prepared with above procedure of repowdering of pellet, the formed film showed a superconductivity at the temperature of liquid nitrogen.

Though it is still not certain, following speculation seems plausible. If the source powder is added with the supplemental amount of $Y_2 O_3$ and powder of metallic Cu at the beginning of the pellet making, it will never construct a rhombic perovskite structure by the sintering. Because the mixing rate is different from ideal rate of 1:2:3. Accordingly, if such pellet is used as a source of the electron evaporator, the formed film contains only a few amount of the rhombic perovskite structure, which is essential for superconductor material. So, it is difficult to show the superconductivity unless it is cooled to the liquid helium temperature. On the contrary, once the pellet is sintered using a mixed powder of $Y_2 O_3$, $BaCO_3$ and $CuO$ having a mixing rate of 1:2:3 in atomic ratio of Y, Ba and Cu, the sintered pellet will have a structure of the rhombic perovskite of $Y_1 Ba_2 Cu_3 O_x$. This has been ascertained by an X-ray crystallography. So, when such pellet is powdered again, the powder reserves the rhombic perovskite structure, and the structure is transferred to the film. The added powders of $Y_2 O_3$ and metallic Cu might be crystallized around the original seed crystal of $Y \cdot Ba_2 Cu_3 O_x$, covering the loss of Ba and Cu caused by electron bombardment.

Another reason is considered that, by the first sintering, which is carried on in an air ambient, carbon (C) is perfectly removed. Carbon is undesirable for crystallizing $Y_1 Ba_2 Cu_3 O_x$.

Next, the method for fabricating the source pellet will be described. A first mixture of

1 2 $Y_2 O_3$ + 2 $BaCO_3$ + 3 $CuO$ in mole ratio

4

is prepared, and prebaked in an air ambient at 800 - 950° C for 5 - 50 hours, preferably at 850° C for 10 hours. The baked material is powdered, mixed and pressed in a form of pellet by 300 kgf/cm². The pellet is a cylindrical one, 3 cm in diameter and 3 cm high. The pellet is sintered in an air ambient at 900 - 1,000° C for 5 - 50 hours, preferably at 950° C for 10 hours, and cooled slowly to a room temperature with a cooling rate of 0.5° C/min, for example. By this sintering process, called first sintering hereinafter, the pellet becomes a sintered body of $Y_1 Ba_2 Cu_3 O_x$ having a rhombic perovskite structure. And carbon which is undesirable for forming the crystal is removed.

Succeedingly, the pellet is powdered again (repowdered). And added supplemental powder of $Y_2 O_3$ with a mixing rate of 4-6 parts of Y, and 1 part of metallic Cu powder each for 1 part of Ba in the first mixture, each in atomic ratio of Y and Cu. And explained above, the amount of the added supplemental elements are depending upon the vapor pressure of the oxide of the added supplemental elements. The mixing rate 4-7 for Y in the second mixture is also varied depending on the energy of electron beam used for the evaporation. For a higher energy, the rate is decreased to 4, and for a lower energy, the rate is increased to 7. That is, the lower the vapor pressure is, the larger amount of element should be added. After adding the supplemental elements to the repowdered pellet according to the above rate, the second powder is mixed well, pressed to a pellet and sintered again. The sintering has been carried on in an oxygen ($O_2$) ambient at 450 - 500° C for 2 - 8 hours, preferably at 500° C for 2 hours. This sintering is called second sintering hereinafter, and a pellet prepared in such a way is call repowdered pellet hereinafter to identify it from ordinary (only once sintered) pellet.

Such repowdered pellet is used for the source of an electron beam evaporator as shown in Fig. 1. The electron beam of 8.3 kV 100 mA was used for the repowdered pellet including a supplemental Y rate of 6.5 parts per 1 Ba, for example. For a higher electron beam energy, 9.0 keV for example, the rate of the supplemental Y is decreased to 4. While the rate of the supplemental Y is increased to 7 for a lower electron beam energy of 6.5 keV for example. The repowdered pellet 3 was evaporated by the electron beam, and deposited on the substrate 9 which is supported by a holder 8 facing toward the pellet 3. The evaporation chamber 1 is evacuated to $1 \times 10^{-6}$ Torr, but the pressure in the chamber increased to $1 \times 10^{-5}$ Torr during the deposition, because oxygen is introduced into the chamber through the pipe 10. During the evaporation, the substrate is heated up to 600° C by a heater 9 provided in the holder 8. The substrate made of sapphire, crystallized magnesium oxide (MgO) or strontium titanade ($SrTiO_3$) is used. Under such condition, the growing rate of the film of $Y_1 Ba_2 Cu_3 O_x$ was about 5 A°/sec.

The film was annealed in an oxygen ambient for two hours at 900° C, succeedingly for 4 hours at 450° C. Then the film showed a superconductivity at a liquid nitrogen temperature (77° K).

The above embodiment was described with respect to a $Y_1 Ba_2 Cu_3 O_x$ material. But it will be easily understood for the one skilled in the art that the spirit of the invention can be applied over other types of materials having the same rhombic perovskite structure, by replacing the element atom of yttrium (Y) with other rare earth atoms, such as Sc, La, Nd, Sm, Gd, Dy, Ho, Er, Tm, Lu, Pm, Eu or Yb, by simple replacement of element or modification of the process conditions.

In the above disclosure of the embodiment, the evaporation of the pellet has been done using an electron beam evaporator, but it may be replaced by an electronic heater using a resistive filament.

Next a second embodiment of the present invention will be described. In this embodiment, a method for forming a superconductive film composed of a (Bi•Sr•Ca•Cu•O) compound will be described. This compound is discovered to operate at a higher temperature than $RE_1 Ba_2 Cu_3 O_x$ compound, and is more stable against water. Further detail about the (Bi•Sr•Ca•Cu•O) compound is given for example in "A New High-Tc Oxide Superconductor without a Rare Earth Element" by H. Maeda et al., Japanese. Jour. of Appl. Phys. vol. 27, No. 2, Feb. 1988, pp L.209-L210.

For this compound, the chemical formula is still not clear. Therefore, it is difficult to mix the component materials according to the chemical formula. So, in a similar manner to the first embodiment, powders of $Bi_2 O_3$, $SrCO_3$, $CaCO_3$ and CuO has been mixed with an atomic ratio of (Bi:Sr:Ca:Cu = 1:1:1:2) which is considered to be the ideal ratio of the superconductive material. But using such material as a source of the electron beam evaporator, it has been found that components of the grown film has the mixing ratio of (Bi:Sr:Ca:Cu = 1:0.1:0.1:2). There is a great shortage of Sr and Ca. And the film did not show the superconductivity. The reason was considered due to a lower evaporation rate of SrO and CaO, which are converted from $SrCO_3$ and $CaCO_3$ by the prebaking, caused by a lower vapor pressure of these materials. So, these elements have been supplemented to the source powder, and the optimum rate of mixture was determined experimentally. The condition found by the inventor will be described.

The pellet for the source of the electron beam evaporator was prepared in following steps:

1. Powders of bismuth oxide ($Bi_2O_3$), strontium carbonate ($SrCO_3$), calcium carbonate ($CaCO_3$) and copper oxide ($CuO$) are mixed. The mixing ratio was 1:8:14:4 in atom of Bi, Sr, Ca, Cu for a sample A, and 1:8:16:3 in atom for a sample B.

2. The mixed powder was prebaked at 800 - 870° C for 5 - 50 hours, preferably at 850° C for 3 hours in an air ambient.

3. The prebaked powder was powdered again, and pressed in a form to a cylindrical pellet of 3 cm in diameter and 3 cm high.

4. The pellet is sintered in an air ambient at 850 -880° C for 5 - 50 hours, preferably at 850° C for 10 hours.

In this embodiment the "repowdering" of the pellet was unnecessary. The evaporation condition for such fabricated pellet was as follows:

the electron beam energy was 300 W;

the chamber was evacuated to $1 \times 10^{-6}$ Torr;

the substrate of crystallized MgO or $SrTiO_3$ was heated up to 180° C by a heater in the holder; and

the holder of the substrate was rotated around its axis at a speed of 6-10 turns/min.

Under such condition, the growing rate of the evaporated film was 7-8 A°/sec. The film was annealed in an air ambient at 850 - 880° C for 3 - 120 min.

Chemical analysis showed the mixing ratio of the components of the grown film were as follows.

| Sample | Bi(atom) | Sr(atom) | Ca(atom) | Cu(atom) |
|--------|----------|----------|----------|----------|
| A | 1 | 0.85 | 0.67 | 1.65 |
| B | 1 | 0.51 | 0.63 | 1.17 |

These mixing rates are not so close to the ratio of Bi:Sr:Ca:Cu = 1:1:1:2 in rhombic perovskite. But they are fairly close to the mixing ratio for a (Bi•Sr•Ca•Cu•O) compound known as

1:1:1:1.5 for 110° K compound or

1:1:0.5:1 for 80° K compound.

The resistivity of these film was measured varying the temperature.

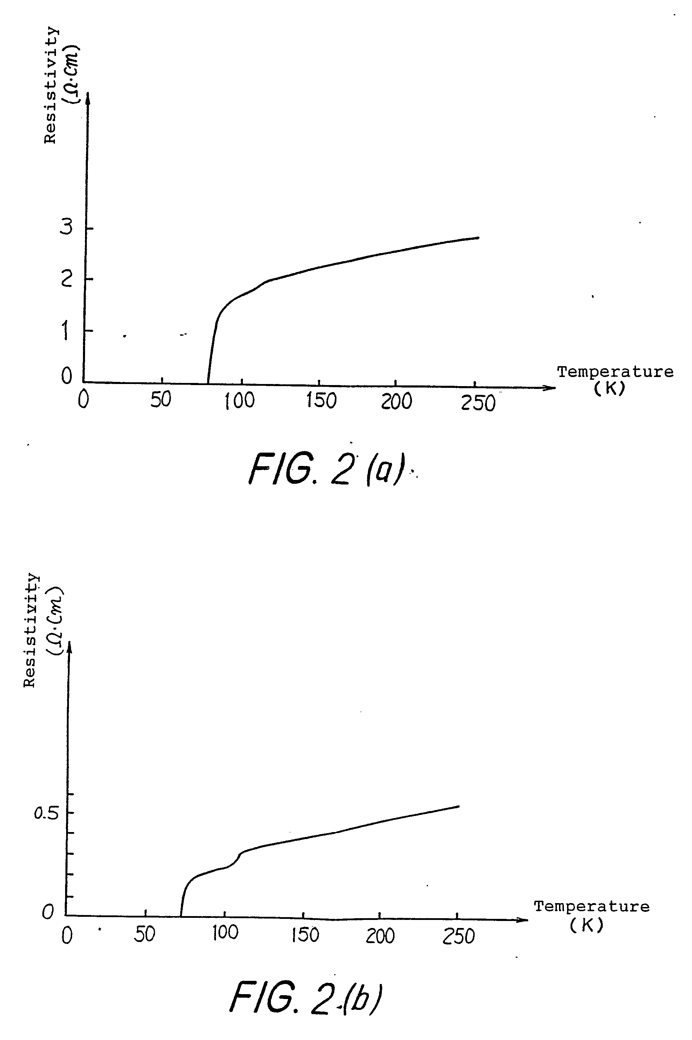

Fig. 2(a) is a temperature dependency of the resistivity of the sample A formed on a MgO substrate;

Fig. 2(b) is a corresponding curve of the sample B formed on a MgO substrate; and

Fig. 2(c) is a curve for the sample B formed on a $SrTiO_3$ substrate. Each of the curve shows the resistivity sharply decreases to zero at nearly 80° K.

These show that, the mixing ratio of the source material of the samples A and B, in which the atomic ratio of Sr and Ca is larger than the chemical formula ratio, compensates the shortage of Sr and Ca in the evaporated film of (Bi•Sr•Ca•Cu•O) compound, and provide a superconductive film formed by electron beam evaporation.

In the above disclosure, an electron beam evaporator has been used for evaporating the pellet. But it will be obvious that other type of heating method such as electrically heated resistive filament may be used.

As can be seen from above experiment, the source of the electron beam evaporator for fabricating the (Bi•Sr•Ca•Cu•O) compound does not need the "repowdering" and second sintering of the pellet, which was important in the first embodiment. The reason is still not clear, but repeating such experiment, the range of mixing ratio of the component material for forming a pellet which can provide a superconductive film has been investigated. The range was rather wide and found to be for one part of ($Bi_2O_3$), 3 - 15 parts of $SrCO_3$, 4 - 30 parts of $CaCO_3$ and 2 - 5 parts of CuO. If the mixing ratio missed this rage, the superconductive film could not formed.

As has been described above, it has been found that a superconductive film operable at a temperature of liquid nitrogen can be formed by an electron beam evaporator, using a source composed of a mixture of oxide and carbonate of the component elements. The mixing rate of the component material is different from a theoretical mixing rate,.but it is necessary to supplement some elements to compensate a shortage of them in the film, which is caused by a difference between the evaporation rate of the elements. Further, it has been found that, especially for a $RE_1Ba_2Cu_3O_x$ compound, preparation of the source pellet of the electron beam evaporator needs to sinter the mixture of row materials once with a mixing ratio according to chemical formula in order to grow a sintered body of rhombic perovskite. Then it is necessary to "repowder" it, and add the supplemental elements, and sinter again.

**Claims**

1. A method for fabricating a superconductive film including at least first and second component materials in a predetermined atomic ratio, characterized by the steps of:
preparing a source (3) including said first and second materials, an atomic ratio of said first component material against said second component material being larger than said predetermined atomic ratio in case where a vapor pressure of said first component material in said source (3) is lower than a vapor pressure of said second component material in said source (3); and
evaporating said source (3) so as to form said superconductive film on a substrate (7).

2. A method for fabricating a superconductive film as set forth in claim 1, characterized in that said superconductive material is a compound of rare earth element, barium, copper and oxygen ($RE_1Ba_2Cu_3O_x$), said first component material is said rare earth element or said copper, and said second component material is said barium.

3. A method for fabricating a superconductive film as set forth in claim 1, characterized in that said superconductive material is a compound of bismuth (Bi), strontium (Sr), calcium (Ca) and oxygen (Bi•Sr•Ca•Cu•O), said first component material is Sr, Ca, or Cu, and said second component material is Bi.

4. A method for fabricating a superconductive film by evaporating a source (3) including component materials of said film characterized by the steps of:
1) preparing a first mixture by mixing oxide and carbonate of said component materials with a mixing rate according to chemical formula of said superconductor;
2) processing said first mixture with a first sintering process;
3) powdering said sintered first mixture;
4) preparing a second mixture by adding to said powdered first mixture made by the step 3) with supplemental components selected from said first component materials with a predetermined mixing rate;
5) processing said second mixture with a second sintering process so as to make said source (3); and
6) evaporating said source (3).

5. A method for fabricating a superconductive film as set forth in claim 4, characterized in that said supplemental components are a component which are less evaporated comparing to another component.

6. A method for fabricating a superconductive film as set forth in claim 4 or 5, characterized in that said superconductive film is composed of $RE_1Ba_2Cu_3O_x$ compound, where RE is one of rare earth materials.

7. A method for fabricating a superconductive film as set forth in claim 4 or 5, characterized in that said superconductive film is composed of $Y_1Ba_2Cu_3O_x$ compound;
said first mixture is composed of one part of yttrium oxide ($Y_2O_3$), two parts of barium carbonate ($BaCO_3$) and three parts of copper oxide (CuO), each in atomic ratio of yttrium, barium, and copper; and
said supplemental components and their mixing rate are for one part of barium (Ba) in said first mixture, 4-6 parts of $Y_2O_3$, and one part of metallic Cu powder, each in atomic ratio of yttrium, copper and barium.

8. A method for fabricating a superconductive film as set forth in claim 7, characterized in that
in said first sintering process, said first mixture is prebaked in air ambient at 800 - 950° C for 5 - 50 hours, then powdered and pressed to form a pellet and sintered in air ambient at 900 - 1,000° C for 5 - 50 hours; and
in said second sintering process, said second mixture is sintered in air ambient at 450 - 500° C for 2 - 8 hours.

9. A method for fabricating a superconductive film as set forth in claim 1, 3, 4 or 5, characterized in that said superconducting material is composed of a (Bi•Sr•Ca•Cu•O) compound, and said source (3) is composed of a source mixture which is prepared by mixing one part of bismuth oxide ($Bi_2O_3$), 3-15 parts of strontium carbonate ($SrCO_3$), 4-30 parts of calcium carbonate ($CaCO_3$), and 2-5 parts of copper oxide (CuO), each in atomic ratio of Bi, Sr, Ca, and Cu.

10. A method for fabricating a superconductive film as set forth in claim 9, characterized in that said source (3) is prepared in the following steps of:
1) preparing the source mixture;
2) prebaking said source mixture at 800 - 870° C for 5 - 50 hours in an air ambient;
3) powdering said prebaked source mixture, and pressing it to form a pellet; and
4) sintering said pellet in an air ambient at 850 - 880° C for 5 - 50 hours.

FIG. 1

FIG. 2 (c)

FIG. 2 (a)

FIG. 2 (b)